# EUROPÄISCHE PATENTSCHRIFT

(11) **EP 2 680 682 B1**
(45) Veröffentlichungstag und Bekanntmachung des Hinweises auf die Patenterteilung: **16.08.2017**
(21) Anmeldenummer: 13173491.5
(22) Anmeldetag: 25.06.2013
(51) Int. Cl.: H05K 7/20, H02M 1/32

(54) **Verfahren zur Funktionskontrolle eines Kühlsystems eines Wechselrichters und Wechselrichter**
Method for controlling the function of a cooling system of an inverter and inverter
Procédé de contrôle du fonctionnement d'un système de refroidissement d'un onduleur et onduleur

(30) Priorität: 25.06.2012 DE 102012210760
(43) Veröffentlichungstag der Anmeldung: 01.01.2014
(73) Patentinhaber: KACO new energy GmbH, 74172 Neckarsulm (DE)
(72) Erfinder: Haag, Matthias, 74360 Ilsfeld (DE)
(74) Vertreter: Patentanwälte Ruff, Wilhelm, Beier, Dauster & Partner mbB

(56) Entgegenhaltungen:
- EP-A1- 2 413 487
- CN-U- 201 437 792
- US-A1- 2006 130 497
- US-A1- 2007 174 020

## Beschreibung

Die Erfindung betrifft ein Verfahren zur Funktionskontrolle eines Lüfters eines Kühlsystems eines Wechselrichters und einen Wechselrichter.

Ein Wechselrichter wandelt Gleichspannung bzw. Gleichstrom in Wechselspannung bzw. Wechselstrom. Wechselrichter sind üblicherweise Teil von Photovoltaikanlagen und dienen dort der Netzeinspeisung.

Da im Wechselrichter aufgrund der unvermeidlichen Verlustleistung bei der Wechselrichtung Wärme entsteht, weisen Wechselrichter in der Regel ein Kühlsystem mit einem oder mehreren Lüftern auf, das zur Kühlung des Wechselrichters dient.

Da ein nicht erkannter Ausfall des Kühlsystems bzw. Lüfters zu einer Beschädigung oder zu einer ungewollten Leistungsreduzierung des Wechselrichters führen kann, wird in der Regel eine Funktionskontrolle des Lüfters durchgeführt. Beispielsweise erzeugt ein Lüfter hierzu drehzahlabhängig ein so genanntes Tachosignal, welches von einer Steuerung ausgewertet wird. Hierzu ist jedoch Hardware vorzusehen, die zu Mehrkosten des Lüfters führt.

Die EP 2 413 487 A1 zeigt ein Kühlsystem mit Lüftern, bei dem eine ordnungsgemäße Funktion der Lüfter basierend auf einer Stromaufnahme der Lüfter überwacht wird.

Die US 2006/0130497 A1 zeigt ein Verfahren zur Überwachung einer Verstopfung eines Luftfilters, bei dem eine Lüfterdrehzahl verändert wird und anschließend eine Temperaturänderung ermittelt wird. Wenn die Temperaturänderung nicht wie erwartet ausfällt, wird bestimmt, dass der Luftfilter verstopft ist. Die ordnungsgemäße Funktion der Lüfter selbst wird nicht überwacht.

Der Erfindung liegt die Aufgabe zugrunde, ein Verfahren zur Funktionskontrolle eines Lüfters eines Kühlsystems eines Wechselrichters und einen Wechselrichter zur Verfügung zu stellen, die eine kostengünstige Funktionskontrolle des Lüfters ermöglichen.

Die Erfindung löst diese Aufgabe durch ein Verfahren nach Anspruch 1 sowie einen Wechselrichter nach Anspruch 7.

Das Verfahren dient zur Funktionskontrolle eines Lüfters eines Kühlsystems, das herkömmlich zur Kühlung des Wechselrichters dient.

Zur Funktionskontrolle des Lüfters werden folgende Schritte durchgeführt: Ändern einer Kühlleistung des Kühlsystems, wobei die Kühlleistung dadurch geändert wird, dass eine Drehzahl des Lüfters geändert wird, Überprüfen, ob sich eine Temperatur des bzw. innerhalb des Wechselrichters während einer vorgebbaren bzw. vorgegebenen Prüfzeitdauer bei der geänderten Kühlleistung um ein vorgebbares bzw. vorgegebenes Maß verändert, und Bestimmen einer Fehlfunktion des Lüfters, wenn sich die Temperatur nicht um das Maß verändert.

Das Maß der Temperaturänderung kann, neben der Prüfzeitdauer, von weiteren Parametern abhängig sein, beispielsweise vom Grad der Kühlleistungsänderung, von einer Umgebungstemperatur, von einer Anfangstemperatur, von einer momentanen Leistungsabgabe des Wechselrichters, vom Typ des Wechselrichters, etc. Das Maß der Temperaturänderung kann empirisch bei typischen Betriebsbedingungen ermittelt werden, indem im Labor der Lüfter während der vorgegebenen Prüfzeitdauer angeschaltet bzw. abgeschaltet wird und eine Anfangstemperatur am Beginn der Prüfzeitdauer und eine Endtemperatur am Ende der Prüfzeitdauer ermittelt wird. Das Maß ist dann die Differenz zwischen Anfangs- und Endtemperatur.

Der Erfindung liegt die Erkenntnis zugrunde, dass bei einer ordnungsgemäßen Funktion des Lüfters bei einem Ändern der Kühlleistung in Reaktion eine entsprechende Temperaturänderung im überwachten System erfolgen muss. Tritt diese nicht auf, liegt in der Regel eine Fehlfunktion des Lüfters vor, da der Lüfter des Kühlsystems vor dem Abschalten aufgrund eines Fehlers nicht gekühlt hat.

Während eines Normalbetriebs des Wechselrichters, d.h. wenn keine Funktionskontrolle des Lüfters durchgeführt wird, können folgende Schritte durchgeführt werden: Erhöhen einer Drehzahl des Lüfters, wenn eine im Wechselrichter, beispielsweise mittels eines Microcontrollers, erzeugte Kühlanforderung ein Erhöhen der Kühlleistung signalisiert bzw. anfordert, und Reduzieren der Drehzahl des Lüfters, wenn die Kühlanforderung ein Reduzieren der Kühlleistung des Kühlsystems signalisiert bzw. anfordert. Mittels der Kühlanforderung kann herkömmlich ein thermostatisches Regelverhalten realisiert sein, wobei die Lüfterdrehzahl als Stellgröße der thermostatischen Regelung dient. Die Lüfterdrehzahl kann kontinuierlich verändert werden oder lediglich zwei Zustände annehmen, nämlich Lüfter ist an und dreht sich und Lüfter ist aus und dreht sich nicht.

Zur Funktionskontrolle des Lüfters werden während eines Kühlsystemkontrollbetriebs des Wechselrichters, der alternativ zum Normalbetrieb stattfindet, folgende Schritte durchgeführt: Reduzieren der Drehzahl des Lüfters, während die Kühlanforderung ein Erhöhen der Kühlleistung des Kühlsystems anfordert, Überprüfen, ob eine Temperatur innerhalb des Wechselrichters während einer vorgebbaren bzw. vorgegebenen ersten Prüfzeitdauer um ein erstes bestimmtes Maß ansteigt, wobei das erste Maß beispielsweise empirisch ermittelt werden kann und konstant oder betriebszustandsabhängig vorgegeben sein kann, und Bestimmen einer Fehlfunktion des Lüfters, wenn die Temperatur nicht um das erste bestimmte Maß ansteigt.

Entsprechend können alternativ oder zusätzlich folgende Schritte durchgeführt werden: Erhöhen der Drehzahl des Lüfters, wenn die Kühlanforderung ein Reduzieren der Kühlleistung des Kühlsystems anfordert, Überprüfen, ob eine Temperatur innerhalb des Wechselrichters während einer vorgebbaren bzw. vorgegebenen zweiten Prüfzeitdauer, die identisch mit oder unterschiedlich zur ersten Prüfzeitdauer sein kann, um ein zweites bestimmtes Maß abfällt, wobei das erste und das zweite Maß identisch oder unterschiedlich sein können, und Bestimmen einer Fehlfunktion des Lüfters, wenn die Temperatur nicht um das bestimmte zweite Maß abfällt.

Die Kühlanforderung kann ein Erhöhen der Kühlleistung des Kühlsystems signalisieren bzw. anfordern, wenn die Temperatur innerhalb des Wechselrichters größer als eine Solltemperatur ist, und ein Reduzieren der Kühlleistung des Kühlsystems signalisieren bzw. anfordern, wenn die Temperatur innerhalb des Wechselrichters kleiner als die Solltemperatur ist.

Die Kühlanforderung kann alternativ oder zusätzlich ein Erhöhen der Kühlleistung des Kühlsystems signalisieren bzw. anfordern, wenn der Wechselrichter eine Ausgangsleistung erzeugt, die größer als ein Schwellwert ist, und ein Reduzieren der Kühlleistung des Kühlsystems signalisieren bzw. anfordern, wenn der Wechselrichter eine Ausgangsleistung erzeugt, die kleiner als der Schwellwert ist. Dies trägt der Tatsache Rechnung, dass bei höherer Ausgangsleistung auch die Wärme erzeugende Verlustleistung zunimmt, die ein Kühlen des Wechselrichters notwendig macht.

Der Kühlsystemkontrollbetrieb kann alternierend zum Normalbetrieb zyklisch widerholt werden, beispielsweise einmal pro Tag.

Die erste Prüfzeitdauer und/oder die zweite Prüfzeitdauer kann/können beispielsweise in einem Bereich zwischen 10 Sekunden und einer Stunde liegen. Die erste Prüfzeitdauer und/oder die zweite Prüfzeitdauer können in Abhängigkeit von thermischen Zeitkonstanten des Wechselrichters gewählt werden, die beispielsweise empirisch für verschiedenen Wechselrichtertypen bestimmt werden können. Die erste Prüfzeitdauer und/oder die zweite Prüfzeitdauer können von einer Gerätegröße, einem Gerätevolumen, einer Geräteleistungsklasse usw. abhängig sein.

Der Wechselrichter weist auf: mindestens ein Kühlsystem mit einem Lüfter zur Kühlung des Wechselrichters, mindestens einen Temperatursensor zur Messung einer Temperatur innerhalb des Wechselrichters, beispielsweise in einem Gehäuseinneren, und/oder zur Messung der Temperatur von Leistungshalbleitern, und eine Steuereinheit, die mit dem Kühlsystem und dem Temperatursensor in Wirkverbindung steht. Die Steuereinheit ist zur Durchführung des oben genannten Verfahrens ausgebildet.

Die Erfindung wird nachfolgend unter Bezugnahme auf die Zeichnungen beschrieben. Hierbei zeigt schematisch:
- Fig. 1: einen Wechselrichter mit einer erfindungsgemäßen Funktionskontrolle seines Kühlsystems und
- Fig. 2: eine zeitliche Abfolge von Normalbetrieb und Kühlsystemkontrollbetrieb des in Fig. 1 gezeigten Wechselrichters.

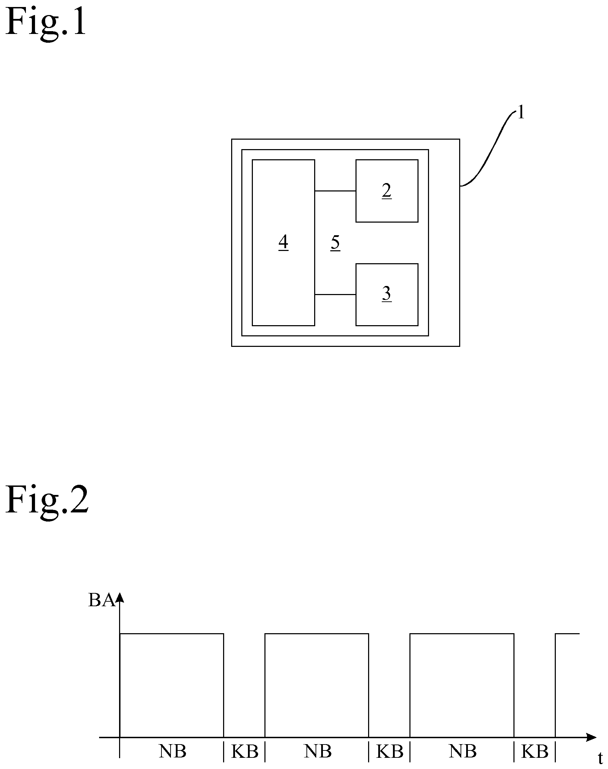

Fig. 1 zeigt einen Wechselrichter 1 mit einem zugehörigen Kühlsystem 5, welches eine Betriebstemperatur des Wechselrichters 1 herkömmlich thermostatisch regelt.

Das Kühlsystem 5 umfasst einen Lüfter 2, einen Temperatursensor 3 zur Messung einer Temperatur innerhalb eines nicht näher dargestellten Gehäuses des Wechselrichters 1, eine Steuereinheit in Form eines Mikrocontrollers 4, der eine Drehzahl des Lüfters 2 vorgibt und den Temperatursensor 3 auswertet, und nicht gezeigte Kühlkanäle, die zur Führung von Kühlluftströmen dienen.

Der Lüfter 2 generiert kein Tachosignal, d.h. ist tachosignalgeneratorfrei.

Zur Funktionskontrolle des Kühlsystems 5 ändert der Microcontroller 4 die Kühlleistung des Kühlsystems 5, indem er den Lüfter 2 beispielsweise ein- bzw. ausschaltet oder eine Lüfterdrehzahl verändert. Anschließend überprüft der Microcontroller 4 bei gleichbleibendem, zuvor eingestellten Lüfterzustand bzw. gleichbleibender, zuvor eingestellter Lüfterdrehzahl, ob sich eine Temperatur innerhalb des Wechselrichters 1 während einer Prüfzeitdauer, beispielsweise 10 Minuten, um ein bestimmtes Maß, beispielsweise 10° K, verändert. Der Microcontroller 4 bestimmt eine Fehlfunktion des Kühlsystems 5, wenn sich die Temperatur nicht um das bestimmte Maß verändert.

Eine detaillierte Beschreibung des Wechselrichterbetriebs erfolgt nun unter Bezug auf Fig. 2, die eine Betriebsart BA des Wechselrichters 1 über der Zeit darstellt.

Wie in Fig. 2 gezeigt, wechseln sich ein Normalbetrieb NB und ein Kühlsystemkontrollbetrieb KB zyklisch ab, wobei der Kühlsystemkontrollbetrieb KB in Kontrollzyklen von ca. 10 Minuten Dauer beispielsweise alle 24 Stunden durchgeführt werden kann.

Während des Normalbetriebs NB wird der Lüfter 2 angeschaltet, wenn eine Kühlanforderung, die im Microcontroller 4 erzeugt wird, ein Anschalten des Lüfters 2 signalisiert bzw. anfordert. Dies ist beispielsweise bei einem Überschreiten einer Schwelltemperatur und/oder beim Überschreiten einer Wechselrichterausgangsleistung der Fall. Entsprechend wird der Lüfter 2 abgeschaltet, wenn die Kühlanforderung ein Abschalten des Lüfters 2 signalisiert bzw. anfordert. Dies entspricht einem herkömmlichen Lüfterbetrieb. Anstelle eines vollständigen An- bzw. Abschaltens des Lüfters kann auch eine Drehzahlerhöhung bzw. eine Drehzahlreduzierung erfolgen.

Während des Kühlsystemkontrollbetriebs KB wird der Lüfter 2 abgeschaltet, wenn die Kühlanforderung ein Einschalten des Lüfters 2 signalisiert bzw. anfordert, so dass die Temperatur theoretisch ansteigen müsste. Der Microcontroller 4 überprüft, ob die Temperatur innerhalb des Wechselrichters 1 während einer Prüfzeitdauer um ein bestimmtes Maß ansteigt. Falls die Temperatur nicht um das bestimmte Maß ansteigt, stellt der Microcontroller 4 eine Fehlfunktion des Kühlsystems 5 fest und stellt einen sicheren Zustand des Wechselrichters 1 her, indem er beispielsweise die Netzeinspeisung abschaltet oder auf eine angepasste Maximalleistung begrenzt.

Zur Funktionskontrolle des Kühlsystems 5 kann der Lüfter 2 auch angeschaltet werden, wenn die Kühlanforderung ein Abschalten des Lüfters 2 signalisiert bzw. anfordert. Für diesen Fall wird überprüft, ob die Temperatur innerhalb des Wechselrichters 1 während der Prüfzeitdauer um ein bestimmtes Maß abfällt. Tut sie dies nicht, wird ebenfalls eine Fehlfunktion des Kühlsystems 5 festgestellt.

Die Fehlfunktion kann durch einen fehlerhaften Lüfter 2 verursacht sein, der sich beispielsweise nicht mehr dreht. Die Fehlfunktion kann jedoch auch durch Versagen eines Kühlkanals verursacht werden, falls Verschmutzung im Kühlkanal einen Luftstrom durch den Kühlkanal behindert oder gar verhindert.

Erfindungsgemäß kann die Funktion des Kühlsystems 2 auch ohne Tachosignal überprüft werden, indem der Betriebszustand des Lüfters 2 bewusst verändert und anschießend ein Temperaturverlauf gemessen und mit einem erwarteten Temperaturverlauf verglichen wird.

Der Lüfter 2 wird beispielsweise ausgeschaltet, wenn er den Wechselrichter 1 gerade kühlen sollte. Theoretisch müsste die Temperatur des Wechselrichters 1 in der Folge ansteigen. Tut sie dies nicht, kann auf eine Fehlfunktion des Kühlsystems 5 bzw. Lüfters 2 geschlossen werden.

Entsprechend wird der Lüfter 2 in einem Zustand, in dem er (noch) nicht benötigt wird, angeschaltet. In der Folge müsste die Temperatur des Wechselrichters 1 abfallen. Tut sie dies nicht, kann ebenfalls auf eine Fehlfunktion des Kühlsystems 5 bzw. des Lüfters 2 geschlossen werden.

## Patentansprüche

1. Verfahren zur Funktionskontrolle eines Lüfters (2) eines Kühlsystems (5) eines Wechselrichters (1),
**gekennzeichnet durch** die Schritte:
- Ändern einer Kühlleistung des Kühlsystems (5), wobei die Kühlleistung dadurch geändert wird, dass eine Drehzahl des Lüfters (2) geändert wird,
- Überprüfen, ob sich eine Temperatur innerhalb des Wechselrichters (1) während einer Prüfzeitdauer um ein bestimmtes Maß verändert, und
- Bestimmen einer Fehlfunktion des Lüfters (2), wenn sich die Temperatur nicht um das bestimmte Maß verändert.

2. Verfahren nach Anspruch 1, **dadurch gekennzeichnet, dass**
- während eines Normalbetriebs (NB) des Wechselrichters (1) folgende Schritte durchgeführt werden:
- Erhöhen einer Drehzahl des Lüfters (2), wenn eine Kühlanforderung ein Erhöhen der Kühlleistung des Kühlsystems (5) anfordert, und
- Reduzieren der Drehzahl des Lüfters (2), wenn die Kühlanforderung ein Reduzieren der Kühlleistung des Kühlsystems (5) anfordert, und
- wobei zur Funktionskontrolle des Lüfters (5) während eines Kühlsystemkontrollbetriebs (KB) des Wechselrichters (1) folgende Schritte durchgeführt werden:
- Reduzieren der Drehzahl des Lüfters (2), wenn die Kühlanforderung ein Erhöhen der Kühlleistung des Kühlsystems (5) anfordert,
- Überprüfen, ob eine Temperatur innerhalb des Wechselrichters (1) während einer vorgegebenen ersten Prüfzeitdauer um ein erstes bestimmtes Maß ansteigt, und
- wenn die Temperatur nicht um das erste bestimmte Maß ansteigt, Bestimmen einer Fehlfunktion des Lüfters (5);
und/oder
- Erhöhen der Drehzahl des Lüfters (2), wenn die Kühlanforderung ein Reduzieren der Kühlleistung des Kühlsystems (5) anfordert,
- Überprüfen, ob eine Temperatur innerhalb des Wechselrichters (1) während einer vorgegebenen zweiten Prüfzeitdauer um ein zweites bestimmtes Maß abfällt, und
- wenn die Temperatur nicht um das zweite bestimmte Maß abfällt, Bestimmen einer Fehlfunktion des Lüfters (5).

3. Verfahren nach Anspruch 2, **dadurch gekennzeichnet, dass**
- die Kühlanforderung ein Erhöhen der Kühlleistung des Kühlsystems (5) anfordert, wenn die Temperatur innerhalb des Wechselrichters (1) größer als eine Solltemperatur ist, und
- die Kühlanforderung ein Reduzieren der Kühlleistung des Kühlsystems (5) anfordert, wenn die Temperatur innerhalb des Wechselrichters (1) kleiner als die Solltemperatur ist.

4. Verfahren nach Anspruch 2 oder 3, **dadurch gekennzeichnet, dass**
- die Kühlanforderung ein Erhöhen der Kühlleistung des Kühlsystems (5) anfordert, wenn der Wechselrichter (1) eine Ausgangsleistung erzeugt, die größer als ein Schwellwert ist, und
- die Kühlanforderung ein Reduzieren der Kühlleistung des Kühlsystems (5) anfordert, wenn der Wechselrichter (1) eine Ausgangsleistung erzeugt, die kleiner als der Schwellwert ist.

5. Verfahren nach einem der Ansprüche 2 bis 4, **dadurch gekennzeichnet, dass**
- der Kühlsystemkontrollbetrieb zyklisch widerholt wird.

6. Verfahren nach einem der Ansprüche 2 bis 5, **dadurch gekennzeichnet, dass**
- die erste Prüfzeitdauer und/oder die zweite Prüfzeitdauer in einem Bereich zwischen 10 Sekunden und einer Stunde liegen.

7. Wechselrichter (1), umfassend:
- einen Kühlsystem (5) zur Kühlung des Wechselrichters (1), wobei das Kühlsystem einen Lüfter (2) aufweist,
- einen Temperatursensor (3) zur Messung einer Temperatur innerhalb des Wechselrichters (1) und
- eine Steuereinheit (4), die mit dem Kühlsystem und dem Temperatursensor (3) in Wirkverbindung steht,
**dadurch gekennzeichnet, dass**
- die Steuereinheit (4) zur Durchführung des Verfahrens nach einem der Ansprüche 1 bis 6 ausgebildet ist.

## Claims

1. Method for a function check of a fan (2) of a cooling system (5) of an inverter (1), **characterized by** the steps:
- changing a cooling power of the cooling system (5), wherein the cooling power is changed in that a speed of the fan (2) is varied,
- checking, if a temperature within the inverter (1) changes by a certain amount during a test period, and
- determining a dysfunction of the fan (2), if the temperature does not change by the certain amount.

2. Method according to claim 1, **characterized in that**
- during a normal operation (NB) of the inverter (1) the following steps are executed:
- increasing a speed of the fan (2), if a cooling demand requests an increase in the cooling power of the cooling system (5), and
- reducing the speed of the fan (2), if the cooling demand requests a decrease in the cooling power of the cooling system (5), and
- wherein for a function check of the fan (5) during a cooling system test operation (KB) of the inverter (1) the following steps are executed:
- reducing the speed of the fan (2), if the cooling demand requests an increase in the cooling power of the cooling system (5),
- checking, if a temperature within the inverter (1) increases by a first certain amount during a predefined first test period, and
- if the temperature does not increase by the first certain amount, determining a dysfunction of the fan (5);
and/or
- increasing the speed of the fan (2), if the cooling demand requests a decrease in the cooling power of the cooling system (5),
- checking, if a temperature within the inverter (1) drops by a second certain amount during a predefined second test period, and
- if the temperature does not drop by the second certain amount, determining a dysfunction of the fan (5).

3. Method according to claim 2, **characterized in that**
- the cooling demand requests an increase in the cooling power of the cooling system (5), if the temperature within the inverter (1) is higher than a set-point temperature, and
- the cooling demand requests a decrease in the cooling power of the cooling system (5), if the temperature within the inverter (1) is lower than the set-point temperature.

4. Method according to claim 2 or 3, **characterized in that**
- the cooling demand requests an increase in the cooling power of the cooling system (5), if the inverter (1) produces an output power which is larger than a threshold value, and
- the cooling demand requests a decrease in the cooling power of the cooling system (5), if the inverter (1) produces an output power which is smaller than the threshold value.

5. Method according to any of claims 2 to 4, **characterized in that**
- the cooling system test operation is repeated cyclically.

6. Method according to any of claims 2 to 5, **characterized in that**
- the first test period and/or the second test period are/is in a range between 10 seconds and one hour.

7. inverter (1), comprising:
- a cooling system (5) for cooling the inverter (1), wherein the cooling system includes a fan (2),
- a temperature sensor (3) for measuring a temperature within the inverter (1), and
- a controller unit (4) in operative connection to the cooling system and the temperature sensor (3),
**characterized in that**
- the controller unit (4) is configured for executing the method according to any of claims 1 to 6.

## Revendications

1. Procédé de contrôle du fonctionnement d'un ventilateur (2) d'un système de refroidissement (5) d'un onduleur (1), **caractérisé par** les étapes suivantes:
- modifier une puissance de refroidissement du système de refroidissement (5), dans lequel on modifie la puissance de refroidissement du fait que l'on modifie une vitesse de rotation du ventilateur (2),
- vérifier si une température à l'intérieur de l'onduleur (1) varie dans une mesure déterminée pendant une période de test, et
- déterminer un dysfonctionnement du ventilateur (2), lorsque la température ne varie pas dans la mesure déterminée.

2. Procédé selon la revendication 1, **caractérisé en ce que**:
- pendant un fonctionnement normal (NB) de l'onduleur (1), on exécute les étapes suivantes:
- augmenter une vitesse de rotation du ventilateur (2), lorsqu'une demande de refroidissement demande une augmentation de la puissance de refroidissement du système de refroidissement (5), et
- réduire la vitesse de rotation du ventilateur (2), lorsque la demande de refroidissement demande une réduction de la puissance de refroidissement du système de refroidissement (5), et
- dans lequel pour contrôler le fonctionnement du ventilateur (5) pendant un fonctionnement de contrôle du système de refroidissement (KB) de l'onduleur (1), on exécute les étapes suivantes:
- réduire la vitesse de rotation du ventilateur (2), lorsque la demande de refroidissement demande une augmentation de la puissance de refroidissement du système de refroidissement (5),
- vérifier si une température à l'intérieur de l'onduleur (1) augmente dans une première mesure déterminée pendant une première période de test prédéterminée, et
- lorsque la température n'augmente pas dans la première mesure déterminée, déterminer un dysfonctionnement du ventilateur (5);
et/ou
- augmenter la vitesse de rotation du ventilateur (2), lorsque la demande de refroidissement demande une réduction de la puissance de refroidissement du système de refroidissement (5),
- vérifier si une température à l'intérieur de l'onduleur (1) baisse dans une deuxième mesure déterminée pendant une deuxième période de test prédéterminée, et
- lorsque la température ne baisse pas dans la deuxième mesure déterminée, déterminer un dysfonctionnement du ventilateur (5).

3. Procédé selon la revendication 2, **caractérisé en ce que**
- la demande de refroidissement demande une augmentation de la puissance de refroidissement du système de refroidissement (5), lorsque la température à l'intérieur de l'onduleur (1) est supérieure à une température de consigne, et
- la demande de refroidissement demande une réduction de la puissance de refroidissement du système de refroidissement (5), lorsque la température à l'intérieur de l'onduleur (1) est inférieure à la température de consigne.

4. Procédé selon la revendication 2 ou 3, **caractérisé en ce que**
- la demande de refroidissement demande une augmentation de la puissance de refroidissement du système de refroidissement (5), lorsque l'onduleur (1) produit une puissance de sortie, qui est supérieure à une valeur de seuil, et
- la demande de refroidissement demande une réduction de la puissance de refroidissement du système de refroidissement (5), lorsque l'onduleur (1) produit une puissance de sortie, qui est inférieure à la valeur de seuil.

5. Procédé selon une des revendications 2 à 4, **caractérisé en ce que**
- on répète de façon cyclique le fonctionnement de contrôle du système de refroidissement.

6. Procédé selon une des revendications 2 à 5, **caractérisé en ce que**
- la première période de test et/ou la deuxième période de test se situe(nt) dans une plage comprise entre 10 secondes et une heure.

7. Onduleur (1), comprenant:
- un système de refroidissement (5) pour le refroidissement de l'onduleur (1), dans lequel le système de refroidissement présente un ventilateur (2),
- un capteur de température (3) pour la mesure d'une température à l'intérieur de l'onduleur (1), et
- une unité de commande (4), qui est en liaison active avec le système de refroidissement et le capteur de température (3),
**caractérisé en ce que**
- l'unité de commande (4) est réalisée de façon à exécuter le procédé selon une des revendications 1 à 6.
